# FASCICULE DE BREVET EUROPEEN

(11) **EP 2 330 878 B1**
(45) Date de publication et mention de la délivrance du brevet: **14.03.2018**
(21) Numéro de dépôt: 10193377.8
(22) Date de dépôt: 01.12.2010
(51) Int. Cl.: H05K 7/14

(54) **Dispositif d'extraction pour carte électronique**
Herausziehvorrichtung für elektronische Karte
Extraction device for an electronic card

(30) Priorité: 01.12.2009 FR 0958561
(43) Date de publication de la demande: 08.06.2011
(73) Titulaire: Airbus Operations, 31060 Toulouse (FR)
(72) Inventeur: Colongo, Emile, 31310, Montesquieu Volvestre (FR); Roujean, Olivier, 31200, Toulouse (FR)
(74) Mandataire: Santarelli

(56) Documents cités:
- EP-A1- 1 786 252
- EP-A1- 1 802 188
- DE-A1- 2 525 618
- US-B1- 6 266 248

## Description

La présente invention concerne d'une manière générale les extracteurs de cartes électroniques.

Plus particulièrement, la présente invention concerne les extracteurs de cartes électroniques pour équipements avioniques d'un aéronef.

Les équipements avioniques d'un aéronef sont constitués de calculateurs prenant la forme de cartes électroniques montées dans des boitiers ou cabinets, reliés au faisceau électrique de l'aéronef. En pratique, les cartes électroniques sont montées par l'une de leurs tranches dans une rainure prévue à cet effet sur un socle monté dans un boitier. Le fond du boitier présente une pluralité de connecteurs disposés perpendiculairement au socle, de manière à raccorder électriquement les cartes électroniques montées sur le socle par une tranche perpendiculaire et immédiatement voisine de la tranche montée dans la rainure du socle.

Habituellement, dans un dispositif classique comportant des cartes électroniques, pour démonter une carte électronique, il faut s'assurer d'avoir coupé l'alimentation électrique de la carte électronique pour éviter tout dommage aux composants électroniques avant d'actionner l'extracteur pour extraire la carte.

Dans les équipements avioniques, il existe des équipements modulaires dont l'un des objectifs recherchés est de conserver la disponibilité des différentes fonctions avioniques même lorsqu'une carte électronique donnée est démontée. Concrètement, il s'agit de pouvoir démonter les cartes indépendamment les unes des autres et de faire en sorte que l'équipement soit en mesure d'assurer une fonction donnée malgré l'absence d'une ou de plusieurs cartes électroniques.

En pratique, pour extraire une carte électronique, l'opérateur lance une requête en extraction sur un calculateur central pour une carte donnée. Les autres cartes sont alors reconfigurées pour pouvoir fonctionner sans la carte choisie et l'alimentation de cette dernière est coupée. Un indicateur visuel annonce à l'opérateur qu'il peut extraire la carte.

Cependant, il subsiste le risque que l'opérateur ne démonte pas la carte sur laquelle la requête d'extraction a été effectuée mais une autre carte. Une extraction erronée peut endommager la carte en question. De plus, des disfonctionnements du système peuvent se produire puisque le système n'a pas été reconfiguré pour fonctionner sans la carte extraite par erreur.

Ainsi, le problème est de subordonner l'extraction de la carte à la préparation modulaire des autres cartes électroniques et à la coupure d'alimentation en courant de celle-ci.

Plus généralement, le problème est donc d'empêcher les extractions incorrectes ou erronées des cartes électroniques.

Pour être extraites, les cartes sont munies d'extracteurs en forme de levier permettant de démultiplier un effort d'extraction appliqué sur le levier pour contribuer à extraire la carte.

Le document EP 1 786 252 décrit un dispositif et une méthode pour insérer ou extraire un module enfichable. Le dispositif comprend un levier disposant d'une poignée pour faire pivoter le levier autour d'un axe, un élément de verrouillage par encliquetage qui est apte à verrouiller le levier dans une position pivotée et un élément de déverrouillage associé.

Le document DE 25 25 618 décrit un dispositif de verrouillage électromécanique contre les extractions et/ou insertions erronées d'un module dans des installations mécaniques ou électroniques. L'ouverture du dispositif n'est actionnée qu'après coupure de l'alimentation électrique de l'installation.

Le document EP 1 802 188 décrit un module enfichable comprenant une carte électronique. Le module comprend un levier d'extraction qui comporte un bras de préhension muni d'une bande élastique de guidage qui adhère magnétiquement à une plaque de manière à verrouiller le module en position d'insertion.

En fait, l'évolution du nombre de composants sur les cartes électroniques a conduit à l'augmentation du nombre de contacts entre les cartes et leurs connecteurs. La pression de contact sur chacune des cartes est telle qu'il est nécessaire de prévoir un extracteur. En pratique, une extraction peut demander une force allant jusqu'à 350N. On comprend que sans l'aide d'un extracteur, il est impossible d'extraire la carte.

Partant de ce constat, l'invention propose un dispositif d'extraction pour carte électronique comportant un levier d'extraction pour la carte électronique, le levier étant monté à rotation par rapport à la carte électronique pour que le levier pivote entre une première position et une seconde position, la rotation du levier de la première position vers la seconde position entrainant un mouvement d'extraction de la carte, le dispositif comportant des moyens de blocage en rotation du levier dans la première position qui sont commandés électromagnétiquement.

Ainsi, l'invention propose de verrouiller le levier d'extraction et, en empêchant l'actionnement du levier, de s'opposer à toute extraction erronée de carte.

Ceci garantit une plus grande fiabilité lors des interventions de maintenance.

Avantageusement, selon un premier aspect de l'invention, le dispositif d'extraction pour carte électronique comporte un levier d'extraction pour la carte électronique, le levier étant monté à rotation par rapport à la carte électronique pour que le levier pivote entre une première position et une seconde position, la rotation du levier de la première position vers la seconde position entrainant un mouvement d'extraction de la carte, le dispositif comportant des moyens de blocage en rotation du levier dans la première position qui sont commandés électromagnétiquement, les moyens de blocage comportant un électroaimant destiné à être commandé par un dispositif de commande d'extraction de la carte et agissant sur le levier.

Selon une caractéristique avantageuse de l'invention, la rotation du levier se fait selon un axe parallèle à la direction longitudinale de la carte et le levier présente au moins une portion ferromagnétique faisant face, dans la première position, à une tranche de la carte présentant, au droit de ladite portion ferromagnétique, un électroaimant disposé pour retenir le levier dans la première position.

Ainsi, avantageusement, le levier reste collé du fait de la présence du champ magnétique de l'électroaimant tant que celui-ci est sous tension. En d'autres termes, il s'agit d'un dispositif de blocage passif du levier.

Selon une caractéristique avantageuse de l'invention, la rotation du levier se fait selon un axe parallèle à la direction longitudinale de la carte et le levier présente au moins une portion ferromagnétique faisant face, dans la première position, à une tranche de la carte présentant, au droit de ladite portion ferromagnétique, un électroaimant doublé d'un aimant permanent, de manière à ce que lorsque le courant d'alimentation de l'électroaimant est coupé, le levier soit retenu dans la première position par l'aimant permanent et à ce que, lorsque l'électroaimant est activé, le champ généré annule le champ de l'aimant permanent autorisant ainsi la rotation du levier.

Ainsi, avantageusement, le levier reste collé en permanence en l'absence de courant du fait de la présence d'un champ magnétique généré par l'aimant permanent. Ce champ magnétique est annulé par le champ magnétique produit par l'électroaimant lorsque celui-ci est sous tension. En d'autres termes, il s'agit d'un mode de réalisation actif du dispositif de blocage selon l'invention, puisque même si le courant est coupé, l'aimant retient le levier dans la première position.

Selon des caractéristiques avantageuses de l'invention, éventuellement combinées :
- l'électroaimant est monté sur la tranche de la carte avec au moins un degré de liberté en rotation de manière à s'orienter vers la portion ferromagnétique du levier en présence d'un champ magnétique dans la première position du levier.
- l'électroaimant est monté sur une rotule métallique, elle-même montée sur la carte.
- l'électroaimant est monté sur une pièce en élastomère, elle-même montée sur la carte.

Ainsi, l'efficacité du dispositif est augmentée puisque le contact entre la portion ferromagnétique du levier et les éléments magnétiques est amélioré.

Selon un second aspect de l'invention, le dispositif d'extraction pour carte électronique comporte un levier d'extraction pour la carte électronique, le levier étant monté à rotation par rapport à la carte électronique pour que le levier pivote entre une première position initiale et une seconde position, la rotation du levier de la première position vers la seconde position entrainant un mouvement d'extraction de la carte, le dispositif comportant des moyens de blocage en rotation du levier dans la première position qui sont commandés électromagnétiquement, les moyens de blocage comportant un verrou électromagnétique avec une pige montée en translation et dont la translation est commandé par un électroaimant.

Selon une caractéristique avantageuse, la rotation du levier se fait selon un axe perpendiculaire à la direction longitudinale de la carte et le levier présente un trou suivant un axe parallèle à la direction longitudinale de la carte, le verrou étant fixé par rapport à la carte de manière à ce que la pige puisse rentrer dans le trou pour empêcher la rotation du levier et retenir le levier dans la première position.

Avantageusement, ce mode de réalisation permet de retenir le levier en rotation autour d'un axe parallèle à la direction longitudinale de la carte.

Selon une caractéristique avantageuse de l'invention, le trou est débouchant et la pige est libre en translation lorsque l'électroaimant n'est pas sous tension.

Avantageusement, en cas de panne, dans le cas où le dispositif ne libère pas l'extracteur, l'opérateur peut pousser la tige à l'aide d'un outil tel qu'une aiguille, par exemple depuis l'extérieur, à travers le trou pour libérer le levier extracteur en rotation.

Selon une caractéristique avantageuse de l'invention, le dispositif d'extraction comporte des moyens visuels indiquant que les moyens de blocage sont désactivés.

Ainsi, les risques d'une extraction erronée d'une carte par l'opérateur sont fortement réduits. De plus, l'opérateur peut ainsi repérer la carte sur laquelle la requête d'extraction a été effectuée parmi les cartes du boitier qui se présentent à lui.

Selon un autre aspect, l'invention concerne un dispositif d'extraction pour carte électronique tel que décrit supra, comportant un dispositif de commande d'extraction adapté à :
- recevoir une requête d'extraction pour une carte donnée,
- reconfigurer les autres cartes afin d'assurer la ou les fonctions de la carte à extraire,
- envoyer un signal à l'électroaimant de la carte sélectionnée pour désactiver les moyens de blocage, et
- indiquer que la carte est prête à être extraite par un indicateur visuel.

Selon un autre aspect, l'invention concerne un procédé d'extraction d'une carte électronique à l'aide d'un dispositif d'extraction tel que décrit supra comportant les étapes suivantes :
- lancement d'une requête d'extraction pour une carte donnée,
- identification que la carte est prête à être extraite à l'aide de l'indicateur visuel,
- extraction de la carte en faisant passer le levier de la première à la seconde position.

Selon un autre aspect l'invention concerne un aéronef équipé d'un dispositif d'extraction tel que décrit supra.

L'exposé de l'invention sera maintenant poursuivi par la description détaillée de deux exemples de réalisation, donnée ci-après à titre illustratif et non limitatif, en référence aux dessins annexés. Sur ceux-ci :
- les figures 1a à 1c montrent le principe de fonctionnement d'un levier d'extraction pour carte électronique d'une manière générale ;
- la figure 2 est une vue de côté d'un premier mode de réalisation d'un dispositif d'extraction selon l'invention ;
- la figure 3 est une vue de côté d'un deuxième mode de réalisation d'un dispositif d'extraction pour carte électronique selon l'invention.
- les figures 4a à 4c montrent un principe alternatif de fonctionnement général d'un levier d'extraction pour carte électronique.
- les figures 5a et 4b sont deux vues de côté d'un troisième mode de réalisation d'un dispositif d'extraction selon l'invention, adapté au principe d'extraction des figures 4a à 4c.

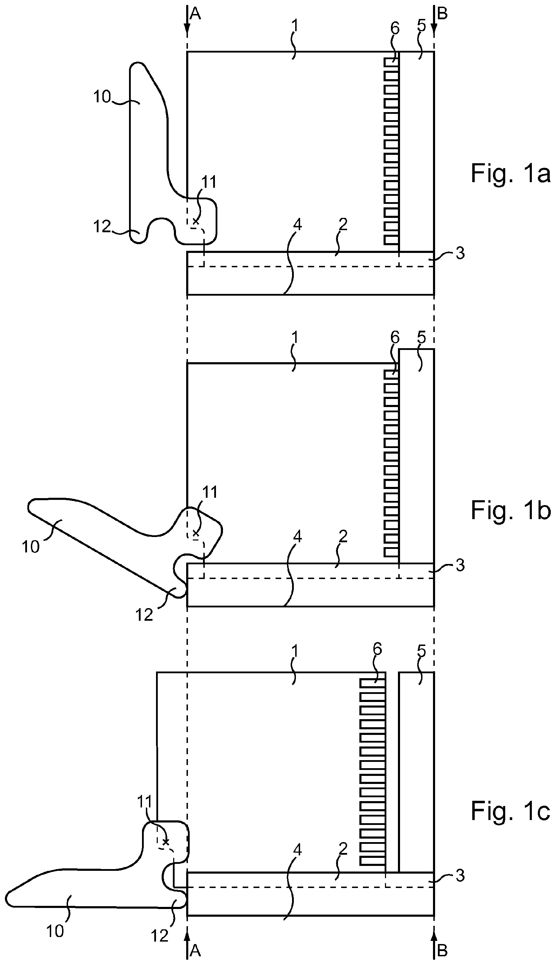

Les figures 1a, 1b et 1c représentent schématiquement en vue de côté, une carte électronique 1 montée par sa tranche inférieure dans une rainure 2 prévue à cet effet dans un socle 3 monté dans un boitier 4. Le fond du boitier 4 présente un connecteur 5 disposé perpendiculairement au socle dans le même plan que la rainure 2 de manière à raccorder électriquement les contacts électriques des cartes électroniques disposées sur une tranche perpendiculaire et immédiatement voisine de la tranche montée dans la rainure du socle.

Sur les figures 1a à 1c on a représenté les contacts électriques de la carte 1, les autres cartes non visibles étant montées parallèlement.

La carte 1 présente à l'extrémité opposée aux contacts électriques 6 un levier 10 monté à rotation sur la carte 1 par l'intermédiaire d'un pivot 11 perpendiculaire à la carte et à la direction longitudinale de celle-ci.

Comme visible plus particulièrement en figures 1b et 1c, lorsque le levier est pivoté autour du pivot 11 depuis une première position (figure 1a) vers une seconde position (figure 1c), une extrémité d'appui 12 du levier prend appui sur une face extérieure du socle 3, en démultipliant la force appliquée à l'extrémité opposée du levier pour la transformer en effort d'extraction de la carte de son connecteur 5.

Les efforts de contact entre les contacts 6 et le connecteur 5 sont tels que l'utilisation d'un levier 10 d'extraction est nécessaire pour extraire la carte 1 du connecteur 5. L'invention tire profit de ce constat en proposant de verrouiller le levier 10 dans la position initiale telle que visible en figure 1a, empêchant ainsi l'extraction de la carte.

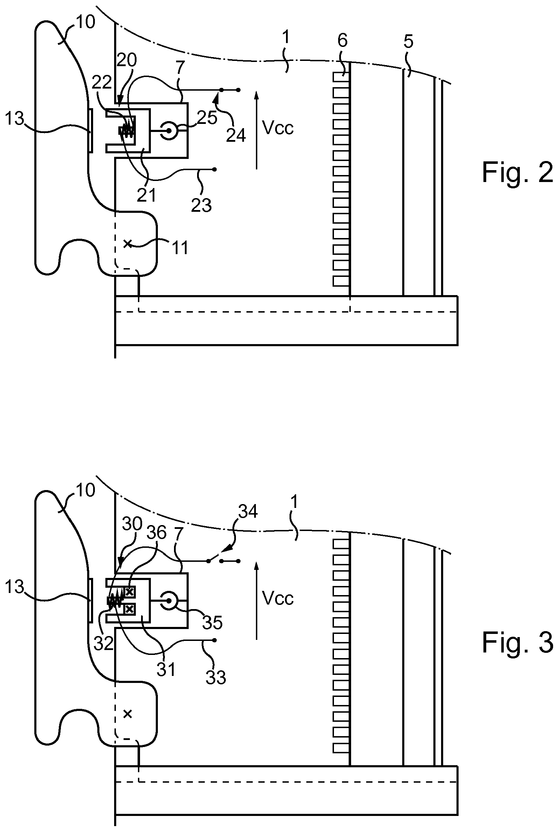

Un premier mode de réalisation d'un dispositif d'extraction selon l'invention est visible en figure 2. Selon le même principe mécanique que sur les figures 1a à 1c, le dispositif d'extraction comporte un levier d'extraction 10 pour la carte électronique 1 monté selon le pivot 11 par rapport à la carte, de manière à ce qu'il puisse pivoter entre une première position et une seconde position. La rotation du levier de la première vers la seconde position entraîne le mouvement d'extraction de la carte tel que visibles aux figures 1a à 1c. Le dispositif d'extraction comporte en outre des moyens de blocage de cette rotation dans la première position. Il s'agit d'une plaque ferromagnétique 13 fixée sur la face intérieure du levier 10 en face d'un évidement 7 prévu dans la carte 1. A l'intérieur de cet évidement est disposé un électroaimant 20 composé d'une âme métallique 21 sur laquelle est installée une bobine électrique 22 alimentée par un circuit électrique 23 soumis à une tension Vcc. Le circuit 23 peut être interrompu à l'aide d'un interrupteur 24.

Lorsque l'interrupteur 24 est fermé, la bobine 22 et l'âme 21 constituent un électroaimant qui génère un champ électromagnétique agissant sur la plaque 13 de manière à retenir le levier plaqué contre la carte, empêchant ainsi sa rotation vers la position d'extraction.

Pour améliorer le contact entre la plaque 13 et l'électroaimant 20, ce dernier est monté selon une liaison rotule 25 sur la carte électronique 1. Ainsi, l'électroaimant est libre de s'aligner parfaitement avec la plaque 13 en présence d'un champ magnétique.

La liaison rotule 25 est réalisée par exemple à l'aide d'une rotule métallique ou d'une liaison souple par l'utilisation d'une pièce en élastomère.

Un mode de réalisation alternatif est représenté en figure 3.

Selon le même principe, le levier 10 présente une plaque ferromagnétique 13 disposée en face d'un électroaimant 30 agencé dans une ouverture 7 prévue à cet effet dans la carte électronique 1.

L'électroaimant 30 est constitué d'une âme 31 sur laquelle est montée une bobine 32 et un aimant permanent 36. De façon analogue au mode de réalisation de la figure 2, la bobine est alimentée par un circuit 33 soumis à une tension Vcc et qui peut être ouvert ou fermé à l'aide d'un interrupteur 34.

L'aimant est dimensionné de manière à ce que, lorsque la bobine n'est pas alimentée, la plaque 13 reste collée à l'électroaimant 30, du fait de la présence d'un champ permanent généré par l'aimant 36. Aucune source d'énergie supplémentaire n'est requise pour maintenir le levier verrouillé dans sa position initiale. Il s'agit donc d'un dispositif de blocage du levier passif, contrairement au mode de réalisation de la figure 2 où une source d'énergie est requise pour maintenir le levier en position initiale ; il s'agit alors d'un dispositif actif.

Pour libérer le levier 10 du mode de réalisation actif de la figure 3, il faut fermer l'interrupteur 34 de manière à alimenter la bobine 32. L'âme 31 génère alors un champ électromagnétique s'opposant au champ permanent de l'aimant de manière à annuler celui-ci et à libérer ainsi la plaque ferromagnétique 13.

En cas de panne d'alimentation électrique, l'opérateur peut tout de même forcer le levier à l'encontre de l'aimant permanent 36 en lui appliquant un effort à l'aide d'un outil tel qu'un tournevis pour pouvoir libérer mécaniquement le levier et extraire la carte.

Avantageusement, les deux modes de réalisation décrits ci-dessus n'ont pas de pièce mécanique en mouvement, ce qui contribue à leur bonne fiabilité.

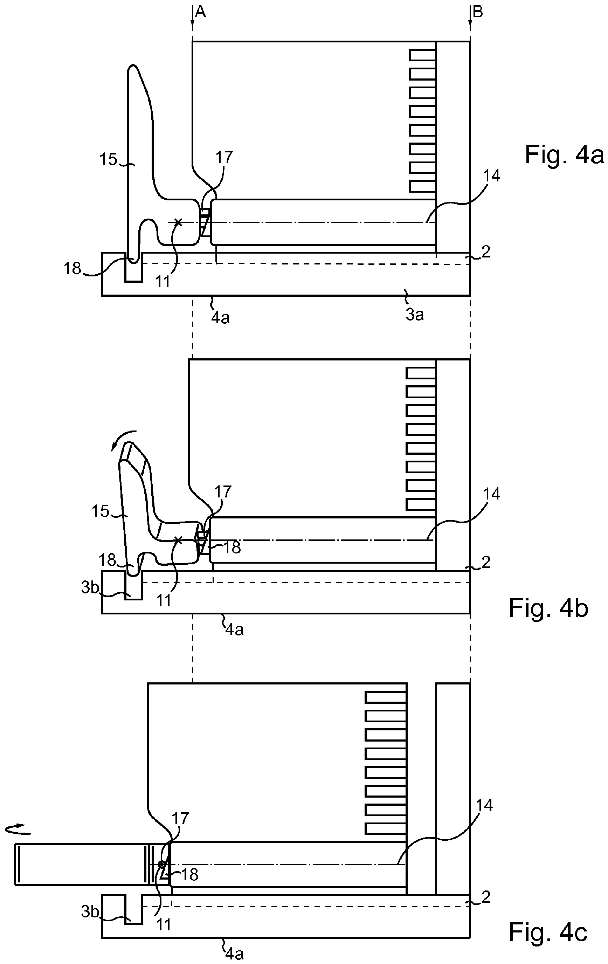

Les figures 4a à 4c représentent un principe alternatif d'extraction d'une carte électronique. Elles reprennent les mêmes références numériques que précédemment pour des éléments sensiblement identiques. La carte 1 est montée par sa tranche inférieure dans une rainure 2 prévue à cet effet dans un socle 3a d'un boitier 4a. Le socle 3a présente une rainure 3b coopérant avec une extrémité 18 d'un levier 15.

Le présent principe d'extraction est similaire à celui décrit en figures 1a à 1c, à la différence près que le levier 15 présente un double axe de rotation par rapport à la carte. En effet, le levier 15 présente, en plus de l'axe matérialisé par le pivot 11, un degré de liberté en rotation longitudinal matérialisé par un arbre 14 de rotation représenté très schématiquement dans une direction parallèle à la direction longitudinale de la porte.

Le dispositif d'extraction visible en figures 4a et 4b fonctionne selon le principe similaire à ceux décrits en figures 4a à 4c. Un pion 17 et une came 18 sont respectivement disposés sur le levier et sur la carte de manière à ce qu'une rotation autour de l'axe 14 contribue à l'extraction de la carte depuis son connecteur via l'extrémité 18 du levier coopérant avec la rainure 3b. L'extraction est ensuite achevée de manière conventionnelle en faisant pivoter le levier 15 autour de l'axe 11. L'extrémité 18 vient alors en appui sur une surface (non représentée) prévue à cet effet sur le socle 3.

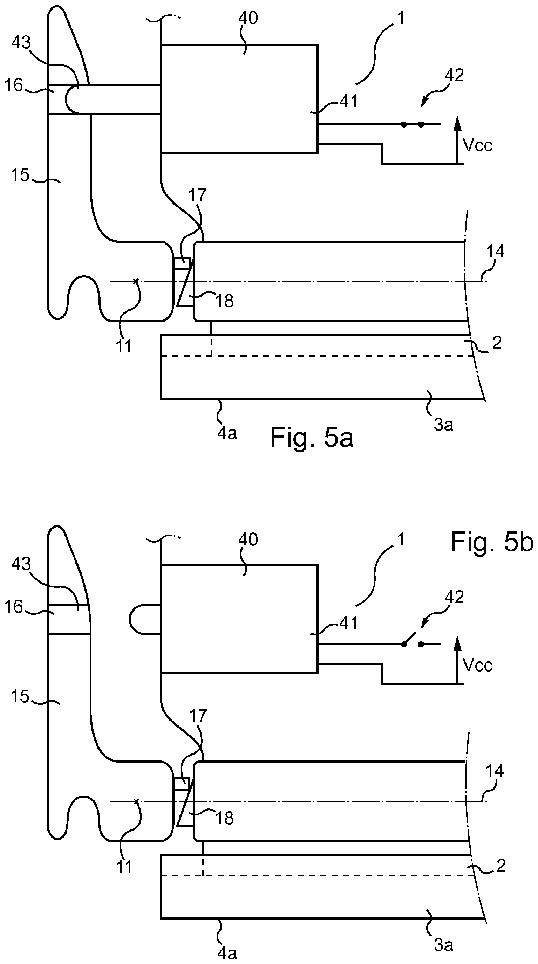

Comme visible en figures 5a et 5b, pour immobiliser le levier 15 dans la position initiale, un verrou 40 est installé sur la carte 1. Il s'agit d'un verrou électromagnétique relié à un circuit électrique 41 alimenté par une tension Vcc et pouvant être fermé à l'aide d'un interrupteur 42. Le verrou électromagnétique présente une pige 43 commandée en translation par un électroaimant non représenté disposé à l'intérieur du verrou électromagnétique 40. La pige 43 est disposée à hauteur d'un trou 16 pratiqué dans le levier 15 de manière à ce que la pige puisse translater vers le levier et pénétrer dans le trou pour empêcher la rotation du levier depuis sa position initiale autour de l'axe 14.

Comme visible plus particulièrement en figure 5b, lorsque le circuit est ouvert à l'aide de l'interrupteur 42, la pige se rétracte à l'intérieur du verrou électromagnétique, libérant ainsi le trou 16 et le levier 15 en rotation.

On comprendra qu'il s'agit d'un mode de réalisation passif dans lequel un courant électrique est nécessaire pour maintenir le levier en position verrouillée. Selon un mode de réalisation non représenté, un fonctionnement actif est prévu de manière à ce que la pige reste en place dans le trou lorsque le courant électrique est coupé. Le retrait de la pige est actionné par la mise sous tension du verrou électromagnétique.

Avantageusement, comme représenté en figures 5a et 5b, le trou 16 est débouchant ce qui permet à l'opérateur, en cas de panne, d'agir directement sur la pige à l'aide d'un outil tel qu'une aiguille, par exemple, pour pousser la pige dans le verrou électromagnétique et libérer ainsi la rotation du levier.

Selon un aspect avantageux de l'invention susceptible de s'appliquer à l'ensemble des modes de réalisation décrits ci-dessus, des moyens d'indication visuels sont prévus sur la carte ou à proximité de celle-ci pour indiquer à l'opérateur que les moyens de blocage sont désactivés. Il s'agit par exemple d'une diode électroluminescente reliée au circuit d'alimentation de l'électroaimant et qui indique si celui-ci est sous tension.

Selon les modes de réalisation, l'opérateur sait, selon que la diode est allumée ou éteinte, si la carte est prête à être extraite.

En pratique, les interrupteurs des circuits d'alimentation des modes de réalisation de l'invention décrits ci-dessus sont commandés par un dispositif de commande pour l'extraction des cartes électroniques. Ce dispositif est adapté à recevoir de l'opérateur une requête d'extraction pour une carte électronique donnée, et à reconfigurer ensuite les autres cartes de manière à ce que celles-ci assurent la ou les fonctions de la carte à extraire. Le dispositif envoie ensuite un signal à l'interrupteur correspondant de la carte pour désactiver les moyens de blocage. En parallèle, si un indicateur visuel est présent, celui-ci est basculé vers un état dans lequel il indique à l'opérateur que la carte choisie est prête à être extraite.

En pratique, l'opérateur lance une requête d'extraction pour une carte donnée sur le dispositif de commande. Il identifie ensuite que la carte en question est prête à être extraite à l'aide de l'indicateur visuel et, les moyens de blocage étant libérés, il agit sur le levier de manière à le faire passer de la première à la seconde position telles que décrites ci-dessus afin d'extraire la carte en question.

L'ensemble des modes de réalisation décrits ci-dessus présentent l'intérêt d'être portés par la carte électronique elle-même. Ils bénéficient donc des cycles de remplacement des cartes électroniques qui ont une durée de vie bien inférieure à celle du dispositif de blocage. Leur fiabilité s'en trouve donc améliorée et rend le dispositif d'extraction selon l'invention particulièrement adapté à équiper des cartes électroniques pour équipement avionique d'un aéronef.

De nombreuses autres variantes sont possibles en fonction des circonstances, et l'on rappelle à cet égard que l'invention ne se limite pas aux exemples décrits et représentés.

## Revendications

1. Dispositif d'extraction pour carte électronique (1) comportant un levier (15) d'extraction pour la carte électronique, le levier étant monté à rotation par rapport à la carte électronique pour que le levier pivote entre une première position et une seconde position, la rotation du levier de la première position vers la seconde position entrainant un mouvement d'extraction de la carte, **caractérisé en ce que** le dispositif comporte des moyens de blocage (13, 20, 16, 43) en rotation du levier dans la première position qui sont commandés électromagnétiquement, les moyens de blocage comportant un électroaimant (20, 40) destiné à être commandé par un dispositif de commande d'extraction de la carte et agissant sur le levier.

2. Dispositif d'extraction selon la revendication 1, **caractérisé en ce que** la rotation du levier (15) se fait selon un axe parallèle à la direction longitudinale de la carte et le levier présente au moins une portion ferromagnétique (13) faisant face, dans la première position, à une tranche de la carte présentant, au droit de ladite portion ferromagnétique, un électroaimant (20) disposé pour retenir le levier dans la première position.

3. Dispositif d'extraction selon la revendication 1, **caractérisé en ce que** la rotation du levier se fait selon un axe parallèle à la direction longitudinale de la carte et le levier présente au moins une portion ferromagnétique (13) faisant face, dans la première position, à une tranche de la carte présentant, au droit de ladite portion ferromagnétique, un électroaimant (20) doublé d'un aimant permanent (36), de manière à ce que lorsque le courant d'alimentation de l'électroaimant est coupé, le levier soit retenu dans la première position par l'aimant permanent et à ce que, lorsque l'électroaimant est activé, le champ généré annule le champ de l'aimant permanent autorisant ainsi la rotation du levier.

4. Dispositif d'extraction selon l'une des revendications 2 ou 3, **caractérisé en ce que** l'électroaimant est monté sur la tranche de la carte avec au moins un degré de liberté en rotation de manière à s'orienter vers la portion ferromagnétique du levier en présence d'un champ magnétique dans la première position du levier.

5. Dispositif d'extraction selon la revendication 4, **caractérisé en ce que** l'électroaimant est monté sur une rotule métallique (25, 35), elle-même montée sur la carte.

6. Dispositif d'extraction selon la revendication 4, **caractérisé en ce que** l'électroaimant est monté sur une pièce en élastomère, elle-même montée sur la carte.

7. Dispositif d'extraction selon l'une quelconque des revendications précédentes, **caractérisé en ce qu'**il comporte des moyens visuels indiquant que les moyens de blocage sont désactivés.

8. Dispositif d'extraction selon l'une quelconque des revendications précédentes, **caractérisé en ce qu'**il comporte un dispositif de commande d'extraction adapté à :
- recevoir une requête d'extraction pour une carte donnée,
- reconfigurer les autres cartes afin d'assurer la ou les fonctions de la carte à extraire,
- envoyer un signal à l'électroaimant de la carte sélectionnée pour désactiver les moyens de blocage, et
- indiquer que la carte est prête à être extraite par un indicateur visuel.

9. Procédé d'extraction d'une carte électronique à l'aide d'un dispositif d'extraction selon la revendication précédente, **caractérisé en ce qu'**il comporte les étapes suivantes :
- lancement d'une requête d'extraction pour une carte donnée,
- identification que la carte est prête à être extraite à l'aide de l'indicateur visuel,
- extraction de la carte en faisant passer le levier de la première à la seconde position.

10. Aéronef équipé d'un dispositif d'extraction selon l'une quelconque des revendications 1 à 8.

## Patentansprüche

1. Vorrichtung zum Herausziehen einer elektronischen Karte (1), umfassend einen Hebel (15) zum Herausziehen der elektronischen Karte, wobei der Hebel drehbar in Bezug zur elektronischen Karte montiert ist, so dass der Hebel zwischen einer ersten Position und einer zweiten Position schwenkt, wobei die Drehung des Hebels von der ersten Position in die Zweite Position zu einer Herausziehbewegung der Karte führt, **dadurch gekennzeichnet, dass** die Vorrichtung Mittel (13, 20, 16, 43) zur Drehfeststellung des Hebels in der ersten Position umfasst, die elektromagnetisch gesteuert sind, wobei die Feststellungsmittel einen Elektromagneten (20, 40) umfassen, der dazu bestimmt ist, von einer Vorrichtung zur Steuerung des Herausziehens der Karte gesteuert zu werden, und der auf den Hebel einwirkt.

2. Herausziehvorrichtung nach Anspruch 1, **dadurch gekennzeichnet, dass** die Drehung des Hebels (15) entlang einer Achse parallel zur Längsrichtung der Karte erfolgt, und der Hebel mindestens einen ferromagnetischen Abschnitt (13) aufweist, der in der ersten Position einem Kartenbereich gegenüberliegt, der im rechten Winkel zu dem ferromagnetischen Abschnitt einen Elektromagneten (20) aufweist, der angeordnet ist, um den Hebel in der ersten Position zu halten.

3. Herausziehvorrichtung nach Anspruch 1, **dadurch gekennzeichnet, dass** die Drehung des Hebels entlang einer Achse parallel zur Längsrichtung der Karte erfolgt, und der Hebel mindestens einen ferromagnetischen Abschnitt (13) aufweist, der in der ersten Position einem Kartenbereich gegenüberliegt, der im rechten Winkel zu dem ferromagnetischen Abschnitt einen durch einen Dauermagneten (36) verdoppelten Elektromagneten (20) aufweist, so dass, wenn der Versorgungsstrom des Elektromagneten unterbrochen ist, der Hebel in der ersten Position durch den Dauermagneten gehalten wird, und dass, wenn der Elektromagnet aktiviert ist, das erzeugte Feld das Feld des Dauermagneten aufhebt, wodurch die Drehung des Hebels gestattet wird.

4. Herausziehvorrichtung nach einem der Ansprüche 2 oder 3, **dadurch gekennzeichnet, dass** der Elektromagnet in dem Bereich der Karte mit mindestens einem Drehungsfreiheitsgrad montiert ist, um sich zu dem ferromagnetischen Abschnitt des Hebels bei Vorhandensein eines Magnetfeldes in der ersten Position des Hebels auszurichten.

5. Herausziehvorrichtung nach Anspruch 4, **dadurch gekennzeichnet, dass** der Elektromagnet auf einem metallischen Kugelgelenk (25, 35) montiert ist, das selbst auf der Karte montiert ist.

6. Herausziehvorrichtung nach Anspruch 4, **dadurch gekennzeichnet, dass** der Elektromagnet auf einem Stück aus Elastomer montiert ist, das selbst auf der Karte montiert ist.

7. Herausziehvorrichtung nach einem der vorhergehenden Ansprüche, **dadurch gekennzeichnet, dass** sie visuelle Mittel umfasst, die anzeigen, dass die Feststellungsmittel deaktiviert sind.

8. Herausziehvorrichtung nach einem der vorhergehenden Ansprüche, **dadurch gekennzeichnet, dass** sie eine Vorrichtung zur Steuerung des Herausziehens umfasst, die geeignet ist:
- einen Antrag zum Herausziehen für eine gegebene Karte zu empfangen,
- die anderen Karten neu zu konfigurieren, um die Funktion(en) der herauszuziehenden Karte zu gewährleisten,
- ein Signal an den Elektromagneten der ausgewählten Karte zu senden, um die Feststellungsmittel zu deaktivieren, und
- durch eine visuelle Anzeige anzuzeigen, dass die Karte bereit ist, herausgezogen zu werden.

9. Verfahren zum Herausziehen einer elektronischen Karte mit Hilfe einer Herausziehvorrichtung nach dem vorhergehenden Anspruch, **dadurch gekennzeichnet, dass** es die folgenden Schritte umfasst:
- Lancieren eines Antrags zum Herausziehen einer gegebenen Karte,
- mit Hilfe einer visuellen Anzeige Identifikation, dass die Karte bereit ist, herausgezogen zu werden,
- Herausziehen der Karte, wobei der Hebel von der ersten in die zweite Position gebracht wird.

10. Flugzeug, das mit einer Herausziehvorrichtung nach einem der Ansprüche 1 bis 8 ausgestattet ist.

## Claims

1. Device for extracting an electronic board (1) including a lever (15) for extracting the electronic board, the lever being mounted so as to be able to rotate with respect to the electronic board such that the lever pivots between a first position and a second position, the rotation of the lever from the first position to the second position bringing about a motion for extracting the board, **characterized in that** the device includes means (13, 20, 16, 43) for rotationally blocking the lever in the first position, which means are controlled electromagnetically, the blocking means including an electromagnet (20, 40) intended to be controlled by a device for controlling the extraction of the board and acting on the lever.

2. Extraction device according to Claim 1, **characterized in that** the rotation of the lever (15) is performed along an axis parallel to the longitudinal direction of the board and the lever has at least one ferromagnetic portion (13) that faces, in the first position, a portion of the board that has, level with said ferromagnetic portion, an electromagnet (20) arranged so as to hold the lever in the first position.

3. Extraction device according to Claim 1, **characterized in that** the rotation of the lever is performed along an axis parallel to the longitudinal direction of the board and the lever has at least one ferromagnetic portion (13) that faces, in the first position, a portion of the board that has, level with said ferromagnetic portion, an electromagnet (20) doubled up with a permanent magnet (36), such that, when the supply current to the electromagnet is cut, the lever is kept in the first position by the permanent magnet and such that, when the electromagnet is activated, the field generated cancels out the field of the permanent magnet, thus allowing the lever to rotate.

4. Extraction device according to either of Claims 2 and 3, **characterized in that** the electromagnet is mounted on the portion of the board with at least a degree of rotational freedom so as to be oriented towards the ferromagnetic portion of the lever in the presence of a magnetic field in the first position of the lever.

5. Extraction device according to Claim 4, **characterized in that** the electromagnet is mounted on a metal ball joint (25, 35) that is itself mounted on the board.

6. Extraction device according to Claim 4, **characterized in that** the electromagnet is mounted on an elastomeric part that is itself mounted on the board.

7. Extraction device according to any one of the preceding claims, **characterized in that** it includes visual means that indicate that the blocking means are deactivated.

8. Extraction device according to any one of the preceding claims, **characterized in that** it includes an extraction control device designed to:
- receive an extraction request for a given board,
- reconfigure the other boards so as to provide the function(s) of the board to be extracted,
- send a signal to the electromagnet of the selected board to deactivate the blocking means, and
- indicate that the board is ready to be extracted by way of a visual indicator.

9. Method for extracting an electronic board using an extraction device according to the preceding claim, **characterized in that** it includes the following steps:
- launching an extraction request for a given board,
- identifying that the board is ready to be extracted using the visual indicator,
- extracting the board by moving the lever from the first to the second position.

10. Aircraft equipped with an extraction device according to any one of Claims 1 to 8.
